# FASCICULE DE BREVET EUROPEEN

(11) **EP 1 955 374 B1**
(45) Date de publication et mention de la délivrance du brevet: **08.04.2009**
(21) Numéro de dépôt: 06830256.1
(22) Date de dépôt: 30.11.2006
(51) Int. Cl.: H01L 25/10, H01L 25/065, H05K 1/14

(54) **MODULE ELECTRONIQUE 3D**
3D-ELEKTRONIKMODUL
3D ELECTRONIC MODULE

(30) Priorité: 30.11.2005 FR 0512169
(43) Date de publication de la demande: 13.08.2008
(73) Titulaire: 3D Plus, 78532 Buc Cedex (FR)
(72) Inventeur: VAL, Christian, F-78470 St Remy les Chevreuse (FR); LIGNIER, Olivier, F-78000 Versailles (FR)
(74) Mandataire: Henriot, Marie-Pierre
(86) Numéro de dépôt international: PCT/EP2006/069164
(87) Numéro de publication internationale: WO 2007/063113

(56) Documents cités:
- EP-A- 0 810 649
- EP-A- 0 844 657
- EP-A- 1 137 066
- WO-A-03/063242
- WO-A-20/04059720
- US-A1- 2004 082 100
- US-A1- 2004 110 323

## Description

Le domaine de l'invention est celui des modules électroniques à 3 dimensions (3D).

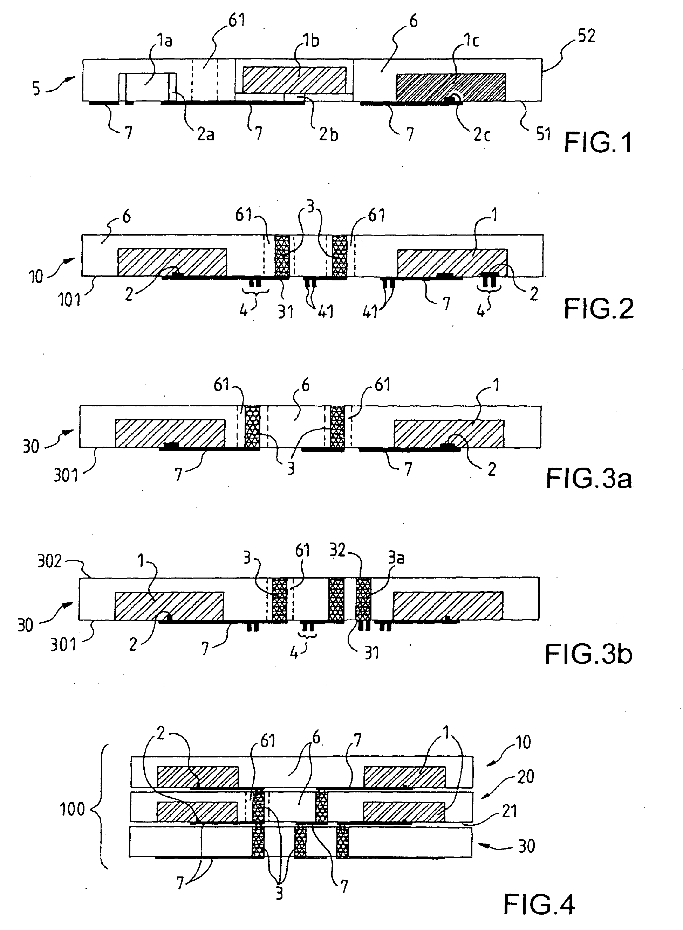

Un module électronique 3 D comprend un empilement de tranches électroniques. Une tranche 5 dont un exemple est représenté figure 1, comprend généralement un ou plusieurs composants actifs 1c, 1b ou passifs 1a qui ont des éléments de connexion électrique 2c, 2b ou 2a affleurant sur l'une des faces 51 de la tranche, les composants étant enrobés dans une résine 6 électriquement isolante. Une ou plusieurs pistes 7 électriquement conductrices situées sur la même face 51 relient ces composants entre eux ou les relient à des éléments de connexion électrique des tranches entre elles ou à des éléments de connexion de la tranche à un circuit d'interconnexion.

Il est connu de relier électriquement les tranches entre elles par des conducteurs situés sur les faces latérales de l'empilement, c'est-à-dire sur les bords 52 des tranches.

Cela se traduit par une importante longueur de connexion électrique pour connecter deux composants notamment lorsqu'ils sont respectivement situés au centre de deux tranches. Or plus la longueur de connexion croît, plus le temps de connexion croît également ce qui réduit globalement les performances du module 3D.

En outre, le nombre de conducteurs situés sur les faces latérales est limité par la surface de ces faces compte tenu en particulier du pas nécessaire. Cette limite du nombre de conducteurs limite d'autant le nombre de signaux routables.

Une autre solution existe pour connecter une première puce munie de plots de connexion et située sur la face inférieure d'une première tranche, avec une deuxième puce également munie de plots de connexion et située face à la première puce, sur la face supérieure d'une deuxième tranche située sous la première : les plots de la première puce comportent des bossages à pointe. Pour l'une et l'autre puce, les plots en aluminium, d'environ 0.2 µm d'épaisseur sont de manière classique recouverts d'une couche d'oxydation en alumine native, très dure d'environ quelques dizaines d'Angström. L'épaisseur des bossages de la première puce est d'environ 30µm. Pour connecter les deux puces, celles-ci sont superposées puis comprimées pour que les bossages de l'une s'encastrent dans le plot de l'autre. Cette solution permet de diminuer la longueur de connexion, et permet d'échapper à la limite sur le nombre de signaux routables, mais le nombre de tranches du module est intrinsèquement limité à deux. Cette solution présente un autre inconvénient. Pour que la connexion électrique soit réalisée, la pression doit être suffisante pour que les bossages traversent la couche d'oxydation, très dure. Dans certains cas, compte tenu de la faible épaisseur du plot, la pression produit une fissure dans la puce.

Une autre solution existe qui concerne le cas particulier d'un empilement de puces qui, de plus sont des puces spécifiques. Chaque puce comprend sur une face un connecteur mâle en l'occurrence un bossage à pointe dure et sur l'autre face une électrode traversante qui constitue un connecteur femelle. Le bossage et l'électrode sont réalisés dans le silicium qui constitue la puce. Lorsque les puces sont superposées pour réaliser le module, le bossage d'une puce s'encastre dans l'électrode de l'autre puce de manière à obtenir la connexion électrique. Cette connexion n'est obtenue qu'au prix d'une extrême précision de placement. De plus, le module obtenu est cher à réaliser en raison du coût élevé de chaque puce qui est spécifique et il ne peut pas être réalisé avec des puces du commerce ni avec des composants passifs.

Une autre solution existante est décrite dans le document US-A1-2004/082 100.

Le but de l'invention est de réaliser un module 3D qui ne présente pas les inconvénients sus-mentionnés.

Plus précisément l'invention a pour objet un module électronique 3D selon la revendication 1 comportant un empilement d'au moins une première tranche et une deuxième tranche, la première tranche présentant sur une face au moins un ensemble de bossages électriquement conducteurs, et la deuxième tranche comprenant au moins une zone de matériau électriquement isolant, traversant la tranche dans l'épaisseur. Il est principalement caractérisé en ce que la deuxième tranche comprend au moins un élément électriquement conducteur traversant ladite tranche dans une zone de matériau électriquement isolant, et apte à recevoir un ensemble de bossages de la première tranche.

De cette façon on obtient un module qui n'est pas limité en nombre de tranches, qui présente une courte connexion électrique entre deux tranches, même au centre de celles-ci et une densité d'interconnexion électrique élevée puisque le nombre de signaux routables n'est pas limité.

Il est peu coûteux car il peut être réalisé avec des puces du commerce.

La première tranche comprend au moins deux composants électroniques munis sur ladite face d'éléments de connexion électrique, ces éléments de connexion étant chacun relié à un ensemble de bossages.

Selon une caractéristique de l'invention, l'élément est relié soit directement à un ensemble soit via une piste conductrice.

La première tranche comprend au moins une zone de matériau électriquement isolant, traversant la tranche dans l'épaisseur, et éventuellement au moins un élément électriquement conducteur traversant ladite tranche dans une zone, relié à un ensemble de bossages de la première tranche. Sur l'autre face opposée à celle qui présente des bossages, cette première tranche comprend éventuellement au moins une piste électriquement conductrice reliée à un élément traversant ladite tranche.

Selon une autre caractéristique de l'invention, la deuxième tranche présente une face apte à recevoir l'ensemble de bossages de la première tranche, dite face réceptrice, cette tranche présentant sur une face opposée à la face réceptrice, au moins une piste électriquement conductrice reliée à un élément traversant.

Avantageusement, la deuxième tranche comprend au moins un composant électronique muni sur ladite face opposée, d'un élément de connexion électrique du composant éventuellement relié à une piste conductrice de la deuxième tranche.

Selon un mode de réalisation de l'invention, la deuxième tranche comprend au moins un ensemble de bossages électriquement conducteurs situés sur la face opposée et reliés à au moins une piste conductrice de ladite tranche.

De préférence, il comprend en outre au moins une tranche intermédiaire qui est une première tranche pour la deuxième tranche et/ou qui est une deuxième tranche pour la première tranche.

Cette tranche intermédiaire comprend au moins un composant et/ou au moins une piste électriquement conductrice.

Selon une caractéristique de l'invention, le ou les éléments traversant comportent du métal ou un alliage métallique ou une colle électriquement conductrice ou un polymère électriquement conducteur.

Le métal ou l'alliage métallique sont de préférence inoxydables ; c'est par exemple de l'or ou du palladium.

Selon une autre caractéristique de l'invention, les bossages comportent du nickel. Leur surface est par exemple en or ou en palladium. Ils présentent une hauteur comprise entre 5 et 200 µm et une section comprise entre 10 et 2500 µm².

L'élément traversant présente avantageusement une section sensiblement circulaire dont le diamètre est sensiblement égal à 100 µm.

Un ensemble de bossages comprend par exemple entre 1 à 500 bossages.

Le module 3D selon l'invention comprend typiquement de 2 à 100 tranches.

Une tranche présente de préférence une épaisseur comprise entre 25 µm et 3 mm.

L'élément traversant d'une tranche et les bossages sont respectivement constitués d'un matériau présentant une dureté déterminée ; la dureté du matériau de l'élément traversant est inférieure à celle du matériau des bossages et apte à minimiser la pression exercée pour que les bossages d'une autre tranche pénètrent dans l'élément traversant.

Pour réaliser le module 3D, les tranches sont superposées et pressées l'une sur l'autre. Grâce à la faible dureté du matériau de l'élément traversant, les bossages pénètrent facilement dans l'élément traversant leur faisant face et il n'est donc pas nécessaire d'exercer une forte pression. Les composants ne risquent donc plus d'être fissurés ou fragilisés mécaniquement lors de cette étape.

D'autres caractéristiques et avantages de l'invention apparaîtront à la lecture de la description détaillée qui suit, faite à titre d'exemple non limitatif et en référence aux dessins annexés dans lesquels :
la figure 1 déjà décrite représente schématiquement une tranche d'un module 3 D selon l'état de la technique,
la figure 2 représente schématiquement un exemple de première tranche d'un module 3D selon l'invention,
les figures 3a et 3b représentent schématiquement deux exemples de deuxième tranche d'un module 3D selon l'invention,
la figure 4 représente schématiquement un exemple de module électronique 3D selon l'invention, comportant trois tranches.

D'une figure à l'autre, les mêmes éléments sont repérés par les mêmes références.

Dans un premier temps, on va considérer un module comportant un empilement de deux tranches, une première et une deuxième tranche.

Selon l'invention, la première tranche 10 dont un exemple est décrit figure 2, comprend sur une face 101 un (ou plusieurs) ensemble(s) 4 de bossages électriquement conducteurs 41.

De préférence, cette tranche comprend en outre au moins un composant électronique 1. Il s'agit d'un composant actif ou un composant passif 1a tel qu'un condensateur, une résistance électrique, un connecteur, ou ... Le composant actif est par exemple une puce nue 1c ou une puce 1b incluse dans un boîtier de protection par exemple en plastique. Le composant peut être un capteur tel qu'un filtre à ondes de surface ou un actuateur. Dans la suite, on considère de manière générale un composant électronique 1. Chaque composant 1 est muni d'un ou plusieurs éléments de connexion électrique. Un élément 2 de connexion électrique est par exemple un plot 2c, un fil 2b, ou une bille constitués d'un matériau électriquement conducteur. Cet élément affleure sur une face 101 de la tranche 10, même lorsqu'il est disposé sur les côtés latéraux du composant comme illustré sur la figure 1 par la référence 2a.

La tranche 10 comporte aussi sur cette face 101 une ou plusieurs pistes conductrices 7, comme déjà indiqué dans le préambule.

L'ensemble 4 de bossages est relié à un élément de connexion électrique 2 d'un composant électronique 1 directement ou via une piste conductrice 7.

Comme représenté figure 2, le composant 1 est habituellement enrobé dans un matériau isolant électriquement 6 tel qu'un polymère diélectrique comme par exemple de la résine époxyde. Il existe ainsi dans la première tranche des zones 61 ne comportant que ce matériau 6 traversant la tranche d'une face à l'autre, dans l'épaisseur de la tranche. Selon une variante de l'invention, la première tranche 10 comprend au moins un élément 3 électriquement conducteur traversant cette tranche de part en part dans une zone 61 ; cet élément 3 est relié à un ensemble 4 de bossages disposés sur la face 101. Ceux-ci sont directement disposés sur l'élément 3 ou lui sont reliés via une piste conductrice. Eventuellement cette piste est elle-même reliée à un élément de connexion d'un autre composant de la même tranche. Cette première tranche comprend éventuellement une ou plusieurs pistes électriquement conductrices disposées sur la face opposée à la face 101.

La zone 61 de matériau isolant présente une constante diélectrique qui peut être adaptée localement autour de l'élément traversant 3 ; cela revient à dire que ce matériau est éventuellement lui-même constitué de plusieurs matériaux isolants.

La deuxième tranche 30 dont un exemple est décrit figure 3a comprend au moins une zone 61 de matériau électriquement isolant, traversant la tranche de part en part dans l'épaisseur, et au moins un élément 3 électriquement conducteur traversant cette tranche dans cette zone 61. Cet élément traversant 3 est destiné à recevoir l'ensemble 4 de bossages de la première tranche 10. On désigne par face réceptrice la face 302 de la tranche destinée à recevoir ces bossages. Selon un mode de réalisation, cette face 302 comporte éventuellement au moins une piste conductrice.

Selon une variante de l'invention dont un exemple est représenté figure 3b la deuxième tranche 30, comprend sur la face 301 opposée à la face réceptrice, au moins un ensemble 4 de bossages 41. Ceux-ci sont connectés à l'élément traversant 3 directement, comme représenté par la référence 3a figure 3b, ou via une piste électriquement conductrice 7. Cette deuxième tranche 30 comprend éventuellement un (ou plusieurs) composant électronique 1 muni d'un élément de connexion 2 relié via une piste conductrice 7 à un autre composant électronique 1 et/ou à un élément traversant 3 et/ou à un ensemble 4 de bossages.

Cette deuxième tranche peut être destinée à être connectée à un élément d'interconnexion du module 3D via ses bossages 41 et/ou ses pistes conductrices 7.

Selon un autre mode de réalisation décrit en relation avec la figure 4, l'empilement 100 du module 3D comprend en plus de ces première et deuxième tranches 10 et 30, au moins une tranche intermédiaire 20 elle-même équipée d'au moins un élément 3 conducteur traversant une zone 61 de matériau électriquement isolant. De manière analogue à la description de la deuxième tranche 30, cette tranche 20 comprend une face réceptrice et une face 21 opposée à cette face réceptrice. L'élément 3 est relié à une piste conductrice 7 de la face 21 de cette tranche. Elle comprend éventuellement des composants 1 et/ou des bossages 41. Cette tranche intermédiaire est une première tranche pour la deuxième tranche et/ou une deuxième tranche pour la première tranche.

Le module 3D selon l'invention comprend typiquement de 2 à 100 tranches. Une tranche présente une épaisseur comprise entre 25 µm et 3 mm. Il est bien sûr destiné à être lui-même connecté à un autre module 3D ou à d'autres supports d'interconnexion.

L'élément traversant 3 est constitué d'un matériau dont la dureté permet de minimiser la pression exercée pour que les bossages 41 d'une tranche pénètrent facilement dans l'élément traversant : la dureté du matériau de l'élément traversant est inférieure à celle du matériau des bossages 41. Cet élément traversant 3, plein, a par exemple la forme d'un cylindre de section circulaire, rectangulaire ou autre. La section est dans le plan des faces 101 ou 301 ou 21. Sa surface est comprise entre 10 et 2500 µm².

Cet élément 3 comporte par exemple du métal ou un alliage métallique ou une colle électriquement conductrice ou un polymère électriquement conducteur. Le métal ou l'alliage métallique est de préférence inoxydable. Ce métal peut être de l'or ou du palladium qui présente l'avantage d'être de faible dureté. Cette dureté peut être adaptée.

Les bossages 41 mesurent par exemple entre 2 et 200 µm de hauteur. Un bossage a par exemple la forme d'un cylindre de section circulaire, rectangulaire ou autre ou d'un cône ou d'une pyramide. La longueur maximale de la section considérée dans le plan des faces 101 ou 301 ou 21 est d'environ 5 à 50 µm. Ils sont par exemple constitués de nickel ; ils sont de préférence recouverts d'or ou de palladium et forment ainsi des pointes dures. Un ensemble 4 de bossages 41 comprend entre 1 et 500 bossages.

On considère la surface de contact d'un ensemble 4 de bossages avec celle d'un élément 3. De préférence, on choisit un nombre de bossages tel que l'ensemble de ces bossages présente à leur base une surface inférieure à celle de l'élément 3 : on obtient ainsi une meilleure tolérance de positionnement d'une tranche sur l'autre que dans le cas où il faut positionner avec précision une puce sur l'autre comme dans l'état de la technique.

Pour réaliser le module 3D, les tranches sont pressées l'une sur l'autre. Lors de cette étape, les bossages 41 à pointes dures pénètrent dans l'élément traversant 3 leur faisant face et de dureté inférieure à celle des bossages, et assurent ainsi un contact électrique entre les deux tranches. Il n'y a donc plus à traverser une couche d'alumine native dure : la pression peut donc être réduite et les composants 1 ne risquent pas d'être fissurés lors de cette étape. De plus, lorsque les bossages 41 sont décalés par rapport aux composants 1, ceux-ci risquent encore moins d'être fissurés.

Lorsque le matériau de l'élément traversant, de l'or en l'occurrence ou du palladium est le même que celui qui recouvre les bossages, il n'y a pas de création intermétallique qui a pour inconvénient de mal vieillir et d'être fragile : la fiabilité de la connexion est donc améliorée.

Le module 3D selon l'invention peut être équipé d'un blindage électromagnétique.

De plus il peut être réalisé selon des techniques classiques de fabrication collective, connues de l'homme du métier.

## Revendications

1. Module électronique 3D comportant un empilement (100) d'au moins une première tranche (10) et une deuxième tranche (30), une tranche comprenant plusieurs composants électroniques (1) munis sur une face (101) de la tranche comprenant d'éléments de connexion électrique (2), la première tranche (10) présentant sur ladite face (101) au moins un ensemble (4) de bossages (41) électriquement conducteurs et au moins une piste (7) électriquement conductrice, au moins un élément (2) de connexion étant relié à un ensemble (4) de bossages (41) via une piste conductrice (7), la première tranche (10) comprenant entre deux composants électroniques au moins une zone (61) de matériau électriquement isolant comprenant traversant la tranche dans l'épaisseur, la deuxième tranche (30) comprenant au moins une zone (61) de matériau électriquement isolant traversant la tranche dans l'épaisseur, et au moins un élément (3) électriquement conducteur traversant ladite tranche dans une zone (61) de matériaux électriquement isolant, le module électronique 3D étant **caractérisé en ce que** l'élément traversant (3) et les bossages (41) sont respectivement constitués d'un matériau présentant une dureté déterminée, la dureté du matériau de l'élément traversant (3) étant inférieure à celle du matériau des bossages (41) de sorte qu'un ensemble (4) de bossages (41) de la première tranche (10) soit enfoui dans un élément traversant (3) de la deuxième tranche (30).

2. Module électronique 3D selon la revendication précédente, **caractérisé en ce que** la première tranche (10) comprend au moins un élément (3) électriquement conducteur, relié à un ensemble (4) de bossages (41) de la première tranche (10), traversant ladite tranche dans une zone (61) de matériau électriquement isolant.

3. Module électronique 3D selon la revendication précédente, **caractérisé en ce que** la première tranche (10) a une autre face opposée à la face (101) présentant des bossages, et **en ce que** cette tranche (10) comprend sur cette autre face au moins une piste électriquement conductrice reliée à un élément électriquement conducteur traversant (3) ladite tranche.

4. Module électronique 3D selon l'une quelconque des revendications précédentes, **caractérisé en ce que** la deuxième tranche (30) présentant une face apte à recevoir l'ensemble (4) de bossages de la première tranche, dite face réceptrice, la deuxième tranche (30) présente sur une face (301) opposée à la face réceptrice, au moins une piste (7) électriquement conductrice reliée à un élément traversant (3).

5. Module électronique 3D selon la revendication précédente, **caractérisé en ce que** la deuxième tranche (30) comprend au moins un composant électronique (1) muni sur ladite face opposée (301), d'un élément (2) de connexion électrique du composant.

6. Module électronique 3D selon la revendication précédente, **caractérisé en ce qu'**une piste conductrice (7) de la deuxième tranche (30) est reliée à l'élément (2) de connexion électrique du composant de ladite tranche (30).

7. Module électronique 3D selon l'une quelconque des revendications 4 à 6, **caractérisé en ce que** la deuxième tranche (30) comprend au moins un ensemble (4) de bossages électriquement conducteurs situés sur la face opposée (301) et reliés à au moins une piste conductrices (7) de ladite tranche.

8. Module électronique 3D selon.,l'une quelconque des revendications précédentes, **caractérisé en ce qu'**il comprend en outre au moins une tranche intermédiaire (20) située entre les première et deuxième tranches (10, 30), comportant au moins une zone (61) de matériau électriquement isolant et au moins un élément (3) de matériau électriquement conducteur traversant ladite zone et au moins un ensemble (4) de bossages électriquement conducteurs, cette tranche intermédiaire étant une première tranche pour la deuxième tranche et/ou une deuxième tranche pour la première tranche.

9. Module électronique 3D selon la revendication précédente, **caractérisé en ce que** la tranche intermédiaire (20) comprend en outre au moins un composant (1) et/ou au moins une piste électriquement conductrice (7).

10. Module électronique 3D selon l'une quelconque des revendications précédentes, **caractérisé en ce que** le ou les éléments traversant (3) comportent du métal ou un alliage métallique ou une colle électriquement conductrice ou un polymère électriquement conducteur.

11. Module électronique 3D selon la revendication précédente, **caractérisé en ce que** le métal ou l'alliage métallique sont inoxydables.

12. Module électronique 3D selon la revendication précédente, **caractérisé en ce que** le métal est de l'or ou du palladium.

13. Module électronique 3D selon l'une quelconque des revendications précédentes, **caractérisé en ce que** le ou les éléments traversant (3) sont pleins.

14. Module électronique 3D selon l'une quelconque des revendications précédentes, **caractérisé en ce que** les bossages (41) comportent du nickel.

15. Module électronique 3D selon l'une quelconque des revendications précédentes, **caractérisé en ce que** la surface des bossages (41) est en or ou en palladium.

16. Module électronique 3D selon l'une quelconque des revendications précédentes, **caractérisé en ce que** le ou les éléments (2) de connexion sont des plots ou des fils ou des billes de connexion.

17. Module électronique 3D selon l'une quelconque des revendications précédentes, **caractérisé en ce que** les bossages (41) présentent une hauteur comprise entre 5 et 200 µm.

18. Module électronique 3D selon l'une quelconque des revendications précédentes, **caractérisé en ce que** les bossages (41) présentent une section comprise entre 10 et 2500 µm².

19. Module électronique 3D selon l'une quelconque des revendications précédentes, **caractérisé en ce que** l'élément traversant (3) présente une section sensiblement circulaire (31 ou 32) dont le diamètre est sensiblement égal à 100 µm.

20. Module électronique 3D selon l'une quelconque des revendications précédentes, **caractérisé en ce que** le composant électronique (1) est un composant actif ou passif.

21. Module électronique 3D selon l'une quelconque des revendications précédentes, **caractérisé en ce que** le composant électronique (1) est un capteur ou un actuateur.

22. Module électronique 3D selon l'une quelconque des revendications précédentes, **caractérisé en ce qu'**un ensemble (4) de bossages comprend entre 1 à 500 bossages (41).

23. Module électronique 3D selon l'une quelconque des revendications précédentes, **caractérisé en ce que** le matériau isolant (6) est un polymère.

24. Module électronique 3D selon l'une quelconque des revendications précédentes, **caractérisé en ce que** la zone (61) de matériau isolant comprend plusieurs matériaux isolants présentant différentes constantes diélectriques afin d'adapter la constante diélectrique localement autour de l'élément électriquement conducteur traversant (3).

25. Module électronique 3D selon l'une quelconque des revendications précédentes, **caractérisé en ce qu'**il comprend de 2 à 100 tranches.

26. Module électronique 3D selon l'une quelconque des revendications précédentes, **caractérisé en ce qu'**une tranche présente une épaisseur comprise entre 25 µm et 3 mm.

## Claims

1. 3D electronic module comprising a stack (100) of at least a first wafer (10) and a second wafer (30), a wafer comprising several electronic components (1) provided on one face (101) of the wafer with electrical connection elements (2), the first wafer (10) having on said face (101) at least one set (4) of electrically conductive protrusions (41), and at least one electrically conductive track (7), at least one connection element (2) being connected to a set (4) of protrusions (41) via a conductive track (7), the first wafer (10) comprising between two electronic components at least one zone (61) of electrically insulating material traversing the thickness of the wafer, the second wafer (30) comprising at least one zone (61) of electrically insulating material traversing the thickness of the wafer, and at least one electrically conductive element (3) traversing said wafer in a zone (61) of electrically insulating material, the 3D electronic module being **characterized in that** the traversing element (3) and the protrusions (41) are respectively constituted by a material having a specified hardness, the hardness of the material of the traversing element (3) being less than that of the material of the protrusions (41) such that a set (4) of protrusions (41) of the first wafer (10) is embedded into a traversing element (3) of the second wafer (30).

2. 3D electronic module according to the preceding claim, **characterized in that** the first wafer (10) comprises at least one electrically conductive element (3), connected to a set (4) of protrusions (41) of the first wafer (10), which traverses said wafer in a zone (61) of electrically insulating material.

3. 3D electronic module according to the preceding claim, **characterized in that** the first wafer (10) has another face opposite to the face (101) having protrusions, and **in that** this wafer (10) comprises on that other face at least one electrically conductive track connected to an electrically conductive element (3) traversing said wafer.

4. 3D electronic module according to any one of the preceding claims, **characterized in that** the second wafer (30), having a face able to receive the set (4) of protrusions of the first wafer, called a receiving face, the second wafer (30) has on a face (301), opposite to the receiving face, at least one electrically conductive track (7) connected to a traversing element (3).

5. 3D electronic module according to the preceding claim, **characterized in that** the second wafer (30) comprises at least one electronic component (1) provided, on said opposite face (301), with an electrical connection element (2) of the component.

6. 3D electronic module according to the preceding claim, **characterized in that** a conductive track (7) of the second wafer (30) is connected to the connection element (2) of the component of said wafer (30).

7. 3D electronic module according to any one of Claims 4 to 6, **characterized in that** the second wafer (30) comprises at least one set (4) of electrically conductive protrusions situated on the opposite face (301) and connected to at least one conductive track (7) of said wafer.

8. 3D electronic module according to any one of the preceding claims, **characterized in that** it furthermore comprises at least one intermediate wafer (20) situated between the first and second wafers (10, 30), comprising at least one zone (61) of electrically insulating material and at least one element (3) of electrically conductive material traversing said zone and at least one set (4) of electrically conductive protrusions, this intermediate wafer being a first wafer for the second wafer and/or a second wafer for the first wafer.

9. 3D electronic module according to the preceding claim, **characterized in that** the intermediate wafer (20) furthermore comprises at least one component (1) and/or at least one electrically conductive track (7).

10. 3D electronic module according to any one of the preceding claims, **characterized in that** the traversing element or elements (3) comprise metal or a metal alloy or an electrically conductive adhesive or an electrically conductive polymer.

11. 3D module according to the preceding claim, **characterized in that** the metal or the metal alloy are unoxidizable.

12. 3D electronic module according to the preceding claim, **characterized in that** the metal is gold or palladium.

13. 3D electronic module according to any one of the preceding claims, **characterized in that** the traversing element or elements (3) are solid.

14. 3D electronic module according to any one of the preceding claims, **characterized in that** the protrusions (41) comprise nickel.

15. 3D electronic module according to any one of the preceding claims, **characterized in that** the surface of the protrusions (41) is made of gold or of palladium.

16. 3D electronic module according to any one of the preceding claims, **characterized in that** the connection element or elements (2) are pads or wires or connection balls.

17. 3D electronic module according to any one of the preceding claims, **characterized in that** the protrusions (41) have a height of between 5 and 200 µm.

18. 3D electronic module according to any one of the preceding claims, **characterized in that** the protrusions (41) have a cross-section of between 10 and 2500 µm².

19. 3D electronic module according to any one of the preceding claims, **characterized in that** the traversing element (3) has a substantially circular cross-section (31 or 32) whose diameter is substantially equal to 100 µm.

20. 3D electronic module according to any one of the preceding claims, **characterized in that** the electronic component (1) is an active or passive component.

21. 3D electronic module according to any one of the preceding claims, **characterized in that** the electronic component (1) is a sensor or an actuator.

22. 3D electronic module according to any one of the preceding claims, **characterized in that** a set (4) of protrusions comprises between 1 and 500 protrusions (41).

23. 3D electronic module according to any one of the preceding claims, **characterized in that** the insulating material (6) is a polymer.

24. 3D electronic module according to any one of the preceding claims, **characterized in that** the zone (61) of insulating material comprises several insulating materials having different dielectric constants in order to adapt the dielectric constant locally around the traversing electrically conductive element (3).

25. 3D electronic module according to any one of the preceding claims, **characterized in that** it comprises from 2 to 100 wafers.

26. 3D electronic module according to any one of the preceding claims, **characterized in that** a wafer has a thickness of between 25 µm and 3 mm.

## Patentansprüche

1. 3D-Elektronikmodul mit einem Stapel (100) von mindestens einem ersten Wafer (10) und einem zweiten Wafer (30), wobei ein Wafer mehrere elektronische Bauteile (1) enthält, die auf einer Seite (101) des Wafers mit elektrischen Anschlusselementen (2) versehen sind, wobei das erste Wafer (10) auf der Seite (101) mindestens eine Gruppe (4) von elektrisch leitenden Nocken (41) und mindestens eine elektrische Leiterbahn (7) aufweist, wobei mindestens ein Anschlusselement (2) mit einer Gruppe (4) von Nocken (41) über eine Leiterbahn (7) verbunden ist, wobei das erste Wafer (10) zwischen zwei elektronischen Bauteilen mindestens eine Zone (61) aus elektrisch isolierendem Werkstoff aufweist, der die Dicke des Wafers durchquert, wobei das zweite Wafer (30) mindestens eine zone (61) aus elektrisch isolierendem Werkstoff aufweist, der die Dicke des Wafers durchquert, und mindestens ein elektrisch leitendes Element (3) das Wafer in einer Zone (61) aus elektrisch isolierendem Werkstoff durchquert, wobei das 3D-Elektronikmodul **dadurch gekennzeichnet ist, dass** das durchquerende Element (3) und die Nocken (41) je aus einem Werkstoff bestehen, der eine bestimmte Härte aufweist, wobei die Härte des Werkstoffs des durchquerenden Elements (3) geringer als diejenige des Werkstoffs der Nocken (41) ist, so dass eine Gruppe (4) von Nocken (41) des ersten Wafers (10) in ein durchquerendes Element (3) des zweiten Wafers (30) eingegraben wird.

2. 3D-Elektronikmodul nach dem vorhergehenden Anspruch, **dadurch gekennzeichnet, dass** das erste Wafer (10) mindestens ein mit einer Gruppe (4) von Nocken (41) des ersten Wafers (10) verbundenes elektrisch leitendes Element (3) aufweist, welches das Wafer in einer Zone (61) aus elektrisch isolierendem Werkstoff durchquert.

3. 3D-Elektronikmodul nach dem vorhergehenden Anspruch, **dadurch gekennzeichnet, dass** das erste Wafer (10) eine andere Seite entgegengesetzt zur Nocken aufweisenden Seite (101) hat, und dass dieses Wafer (10) auf dieser anderen Seite mindestens eine elektrische Leiterbahn aufweist, die mit einem das Wafer durchquerenden elektrisch leitenden Element (3) verbunden ist.

4. 3D-Elektronikmodul nach einem der vorhergehenden Ansprüche, **dadurch gekennzeichnet, dass**, während das zweite Wafer (30) eine Seite aufweist, die die Gruppe (4) von Nocken des ersten Wafers aufnehmen kann, Aufnahmeseite genannt, das zweite Wafer (30) auf einer der Aufnahmeseite entgegengesetzten Seite (301) mindestens eine elektrische Leiterbahn (7) aufweist, die mit einem durchquerenden Element (3) verbunden ist.

5. 3D-Elektronikmodul nach dem vorhergehenden Anspruch, **dadurch gekennzeichnet, dass** das zweite Wafer (30) mindestens ein elektronisches Bauteil (1) aufweist, das auf der entgegengesetzten Seite (301) mit einem Element (2) für den elektrischen Anschluss des Bauteils versehen ist.

6. 3D-Elektronikmodul nach dem vorhergehenden Anspruch, **dadurch gekennzeichnet, dass** eine Leiterbahn (7) des zweiten Wafers (30) mit dem Element (2) für den elektrischen Anschluss des Bauteils des Wafers (30) verbunden ist.

7. 3D-Elektronikmodul nach einem der Ansprüche 4 bis 6, **dadurch gekennzeichnet, dass** das zweite Wafer (30) mindestens eine Gruppe (4) von elektrisch leitenden Nocken aufweist, die sich auf der entgegengesetzten Seite (301) befinden und mit mindestens einer Leiterbahn (7) des Wafers verbunden sind.

8. 3D-Elektronikmodul nach einem der vorhergehenden Ansprüche, **dadurch gekennzeichnet, dass** es außerdem mindestens ein Zwischenwafer (20) aufweist, das zwischen dem ersten und dem zweiten Wafer (10, 30) angeordnet ist, mindestens eine Zone (61) aus elektrisch isolierendem Werkstoff und mindestens ein Element (3) aus elektrisch leitendem Werkstoff, das die Zone durchquert, und mindestens eine Gruppe (4) von elektrisch leitenden Nocken aufweist, wobei dieses Zwischenwafer ein erstes Wafer für das zweite Wafer und/oder ein zweites Wafer für das erste Wafer ist.

9. 3D-Elektronikmodul nach dem vorhergehenden Anspruch, **dadurch gekennzeichnet, dass** das Zwischenwafer (20) außerdem mindestens ein Bauteil (1) und/oder mindestens eine elektrische Leiterbahn (7) aufweist.

10. 3D-Elektronikmodul nach einem der vorhergehenden Ansprüche, **dadurch gekennzeichnet, dass** das oder die durchquerende(n) Element(e) (3) Metall oder eine Metalllegierung oder einen elektrisch leitenden Kleber oder ein elektrisch leitendes Polymer aufweist (aufweisen).

11. 3D-Elektronikmodul nach dem vorhergehenden Anspruch, **dadurch gekennzeichnet, dass** das Metall oder die Metalllegierung rostfrei sind.

12. 3D-Elektronikmodul nach dem vorhergehenden Anspruch, **dadurch gekennzeichnet, dass** das Metall Gold oder Palladium ist.

13. 3D-Elektronikmodul nach einem der vorhergehenden Ansprüche, **dadurch gekennzeichnet, dass** das oder die durchquerenden Elemente (3) massiv sind.

14. 3D-Elektronikmodul nach einem der vorhergehenden Ansprüche, **dadurch gekennzeichnet, dass** die Nocken (41) Nickel enthalten.

15. 3D-Elektronikmodul nach einem der vorhergehenden Ansprüche, **dadurch gekennzeichnet, dass** die Fläche der Nocken (41) aus Gold oder Palladium ist.

16. 3D-Elektronikmodul nach einem der vorhergehenden Ansprüche, **dadurch gekennzeichnet, dass** das oder die Anschlusselemente (2) Anschlussklötzchen oder -drähte oder -kugeln sind.

17. 3D-Elektronikmodul nach einem der vorhergehenden Ansprüche, **dadurch gekennzeichnet, dass** die Nocken (41) eine Höhe zwischen 5 und 200 µm haben.

18. 3D-Elektronikmodul nach einem der vorhergehenden Ansprüche, **dadurch gekennzeichnet, dass** die Nocken (41) einen Querschnitt zwischen 10 und 2500 µm² haben.

19. 3D-Elektronikmodul nach einem der vorhergehenden Ansprüche, **dadurch gekennzeichnet, dass** das durchquerende Element (3) einen im Wesentlichen kreisförmigen Querschnitt (31 oder 32) hat, dessen Durchmesser im Wesentlichen gleich 100 µm ist.

20. 3D-Elektronikmodul nach einem der vorhergehenden Ansprüche, **dadurch gekennzeichnet, dass** das elektronische Bauteil (1) ein aktives oder passives Bauteil ist.

21. 3D-Elektronikmodul nach einem der vorhergehenden Ansprüche, **dadurch gekennzeichnet, dass** das elektronische Bauteil (1) ein Sensor oder ein Regler ist.

22. 3D-Elektronikmodul nach einem der vorhergehenden Ansprüche, **dadurch gekennzeichnet, dass** eine Gruppe (4) von Nocken zwischen 1 und 500 Nocken (41) enthält.

23. 3D-Elektronikmodul nach einem der vorhergehenden Ansprüche, **dadurch gekennzeichnet, dass** der isolierende Werkstoff (6) ein Polymer ist.

24. 3D-Elektronikmodul nach einem der vorhergehenden Ansprüche, **dadurch gekennzeichnet, dass** die Zone (61) von isolierendem Werkstoff mehrere isolierende Werkstoffe aufweist, die unterschiedliche Dielektrizitätskonstanten haben, um die Dielektriziätskonstante lokal um das durchquerende elektrisch leitende Element (3) anzupassen.

25. 3D-Elektronikmodul nach einem der vorhergehenden Ansprüche, **dadurch gekennzeichnet, dass** es 2 bis 100 Wafer aufweist.

26. 3D-Elektronikmodul nach einem der vorhergehenden Ansprüche, **dadurch gekennzeichnet, dass** ein Wafer eine Dicke zwischen 25 µm und 3 mm hat.
